(19) **Europäisches Patentamt / European Patent Office / Office européen des brevets**

(11) **EP 4 764 575 A1**

(12) # EUROPEAN PATENT APPLICATION

(43) Date of publication:
24.06.2026 Bulletin 2026/26

(21) Application number: 25214731.9

(22) Date of filing: 10.11.2025

(51) International Patent Classification (IPC):
$G01R\ 33/00$ (2006.01)    $G01R\ 33/038$ (2006.01)
$G01R\ 33/09$ (2006.01)    $G01D\ 5/14$ (2006.01)

(52) Cooperative Patent Classification (CPC):
G01R 33/0005; G01D 5/145; G01R 33/0023;
G01R 33/038; G01R 33/095

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 02.12.2024 LT 2024543

(71) Applicant: Valstybinis Moksliniu Tyrimu Institutas
Fiziniu
Ir Technologijos Mokslu Centras
02300 Vilnius (LT)

(72) Inventors:
• VERTELIS, Vilius
  13107 Vilnius (LT)
• BALEVICIUS, Saulius
  07187 Vilnius (LT)
• STANKEVIC, Voitech
  07100 Vilnius (LT)
• ZURAUSKIENE, Nerija
  08431 Vilnius (LT)
• KERSULIS, Skirmantas
  03205 Vilnius (LT)

(74) Representative: Draugeliene, Virgina Adolfina
Tarpine Ltd
A. P. Kavoliuko g. 24-152
04328 Vilnius (LT)

(54) **MAGNETIC PROXIMITY SENSOR**

(57) The invention relates to magnetic measuring instruments that measure the proximity of a target and its orientation relative to the probe. The probe includes a scalar magnetic field sensor (9) positioned in the magnetic field of a permanent magnet (7). To reduce errors in estimating the target's proximity caused by its orientation, the probe additionally includes a directional magnetic field sensor (10), also positioned in the magnetic field of the permanent magnet (7). Conductive wires are connected to the thin films (2, 3) of the sensors (9, 10), and a current source (11) is connected so that its current flows through the thin films of both sensors, forming a series circuit. Voltage measurement devices are also connected to measure the voltage across the entire circuit and across the individual sensors (9, 10). Based on these measured values, a data processing unit (13) determines the target's (14) distance and orientation relative to the probe.

EP 4 764 575 A1

## Description

## Technical Field

The invention relates to magnetic measuring instruments that measure the proximity of a target and its orientation relative to the probe. The invention can be used in measurement, control, and monitoring systems where distance and orientation measurements are performed.

## State of the Art

Magnetic proximity sensors that use directional magnetic flux density sensors together with a magnet (EP2525193A1, US9733058B2) are known. The disadvantage of such sensors is that when the angle of the target's orientation relative to the sensor is unknown, measurement errors occur unless the geometry of the object is known in advance.

The patent EP3893011B1 describes a scalar magnetic field probe that measures the absolute value of magnetic flux density regardless of its direction. The probe comprises three orthogonally arranged sensors made of thin manganite films formed on a polycrystalline insulating substrate and exhibits changes in electrical resistance depending on magnetic flux density, which does not depend on the field's direction. The limitation of such a proximity meter is that the object under investigation must have a sufficiently strong ($\geq$10 mT) inherent magnetic field, and since the target's orientation relative to the probe is unknown, measurement errors occur if the object's geometry is not known beforehand.

US8189302B2 describes a magnetic field meter that uses a directional magnetic field sensor together with a permanent magnet. A graphene film, which is sensitive to the magnetic field direction, is used to measure the magnetic field in the presence of a constant magnetic field. This design increases the sensitivity of the graphene film to field changes (by exploiting the parabolic magnetoresistance of graphene). The disadvantage of this meter is that accurate distance information is obtained only when the measurement geometry is known in advance.

The closest solution to the proposed invention in terms of technical purpose is a magnetic proximity probe described in a scientific publication (https://doi.org/10.1016/j.sna.2024.115518). This probe includes a scalar magnetic field sensor and a permanent magnet, with the scalar sensor placed in the magnet's field. The sensor has a thin film of material on a dielectric substrate whose electrical resistance depends on magnetic flux density but not on its direction.

The disadvantage of this probe is that when using a single scalar magnetic flux density sensor in the proximity probe, the signal received does not provide information about the direction of the magnetic flux density created by the target (object under investigation) with respect to the probe, so if the measurement geometry is not known in advance, errors occur in determining the proximity of the target with respect to the probe if the geometry of the object under investigation is not known in advance.

## Technical Problem to be solved

The proposed invention aims to expand the functionality of the magnetic proximity probe by enabling simultaneous measurement of the magnetic flux density generated by the target (object under investigation) and its direction relative to the probe, thereby reducing proximity estimation errors caused by target orientation.

## Disclosure of the essence of the invention

The proposed invention provides a magnetic proximity probe, comprising a scalar magnetic field sensor and a permanent magnet, in a magnetic field of which said scalar magnetic field sensor is arranged having a thin film of a material whose electrical resistance varies depending on the magnetic flux density but does not depend on its direction, formed on a dielectric substrate, wherein the probe additionally comprises a directional magnetic field sensor having a thin film formed on the dielectric substrate of a material whose electrical resistance varies depending on the magnetic flux density and its angle to a sensitivity axis Z of the directional magnetic field sensor, wherein both said scalar and directional magnetic field sensors are located in the magnetic field created by the permanent magnet so that the sensitivity axis Z of said directional magnetic field sensor is collinear or perpendicular to a magnetization vector M of the permanent magnet, and electrically conductive wires are connected to both said sensor thin films, forming a sensor system that is hermetically sealed, and said electrically conductive wires are intended:

- for the connection of an electric current source to the thin films of the sensors so that an electrical current of the electric current source can flow sequentially through the thin films of the said scalar and directional sensors, forming a serial electric circuit;
- for the connection of voltage measuring means, enabling measurement of the voltage of the entire said series circuit and the voltage of any of the sensors separately or the voltage of both sensors,

and a data processing means is provided, configured so that based on the voltage values measured by the voltage measuring means it could determine a value and a direction of the magnetic flux created by the target, and from this information, knowing the target's geometry and material, it could determine the distance and orientation of the target relative to the probe.

The respective thin films of the scalar magnetic flux sensor and the directional magnetic flux sensor in the sensor system are formed on the same dielectric substrate on opposite sides thereof, and the dielectric substrate is arranged on the surface of the permanent magnet parallel to or perpendicular to it, so that the sensitivity axis Z of the directional sensor is respectively collinear or perpendicular to the magnetization vector M of the permanent magnet.

Respective thin films of the scalar magnetic flux sensor and the directional magnetic flux sensor in the sensor system are arranged on one side of the same dielectric substrate, wherein the dielectric substrate is arranged on the surface of the permanent magnet parallel to it, and the thin films of the scalar magnetic flux sensor and the directional magnetic flux sensor are arranged on the dielectric substrate one above the other, which are separated by a dielectric interlayer, and the sensitivity axis Z of the directional magnetic flux sensor is collinear with the magnetization vector M of the permanent magnet.

The thin films of the scalar magnetic flux sensor and the directional magnetic flux sensor in the sensor system are formed respectively on separate dielectric substrates, which are arranged on the surface of the permanent magnet, one parallel to it, and the other perpendicularly, so that the sensitivity axis Z of the directional sensor is perpendicular to the magnetization vector M of the permanent magnet.

The probe is configured with the possibility of changing the distance between the permanent magnet and the sensor system, thereby changing density of the magnetic flux created at the position of the thin films.

The material of the thin film of the scalar sensor, whose electrical resistance varies depending on magnetic flux density but does not depend on its direction, is selected from materials characterized by isotropic magnetoresistance, such as polycrystalline lanthanum-strontium-manganese oxide, lanthanum-calcium-manganese oxide, or lanthanum-strontium-manganese-cobalt oxide.

The material of the thin film of the directional sensor, whose electrical resistance varies depending on magnetic flux density and its angle relative to the directional sensor's sensitivity axis Z, is selected from materials with anisotropic magnetoresistance, such as graphene, indium antimonide, indium arsenide, tungsten diselenide, or molybdenum disulfide.

**Advantages of the Invention**

Due to the combination of scalar and direction-sensitive magnetic flux density sensors, the proposed proximity probe can simultaneously measure the amplitude of the magnetic flux vector and its angle to the probe generated by the target, resulting in more accurate distance estimation. Additionally, the proposed magnetic proximity probe is compact, allowing magnetic induction measurements in small volumes.

**Brief description of the drawings**

Fig.1 shows a proposed proximity probe design wherein scalar and directional sensors are formed on opposite sides of a single dielectric substrate, and a directional sensor's sensitivity axis Z is collinear with the magnet's magnetization vector M.

Fig.2 shows a proposed proximity probe design wherein the scalar and directional sensors are formed on opposite sides of a single dielectric substrate, and the directional sensor's sensitivity axis Z is perpendicular to the magnet's magnetization vector M.

Fig.3 shows a proposed proximity probe design wherein the scalar and directional sensors are formed on the same side of a single dielectric substrate with a dielectric interlayer, and the directional sensor's sensitivity axis Z is collinear with the magnet's magnetization vector M.

Fig.4 shows a magnetic proximity probe design wherein the scalar and directional sensors are formed on separate dielectric substrates, and the directional sensor's sensitivity axis Z is perpendicular to the magnet's magnetization vector M.

Fig.5 shows an electrical connection and response measurement scheme for the magnetic field sensors.

Fig.6 shows a scheme for measuring distance and angle relative to the target surface.

Fig.7 shows a dependence of the proximity sensor's circuit voltage and the directional sensor's voltage values on the absolute value of the magnetic flux density induced by the target and its direction (angle relative to the magnetic flux density vector created by the permanent magnet). The grey line with triangle symbols corresponds to the flux density values and directions created by a ferromagnetic plate target located 3 mm from the proximity probe, as the angle β between the plate's normal vector and the directional sensor's sensitive axis changes.

Fig.8 shows a dependence of the voltages of the entire electrical circuit and the direction-sensitive graphene magnetoresistive sensor on the angle β between the normal of the ferromagnetic plate target (located 3 mm from the magnetic proximity and direction probe) and the directional sensor's sensitivity axis.

## Description of the preferred embodiments of the invention

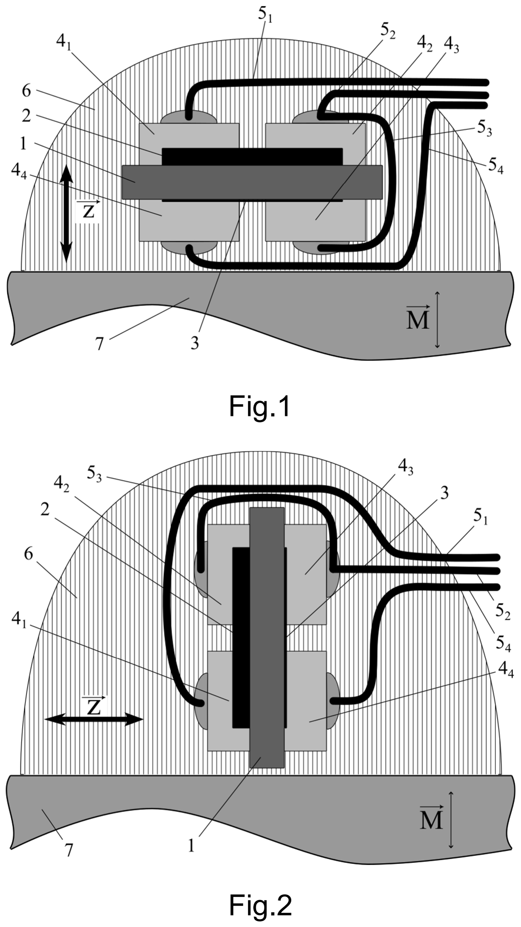

Fig.1 shows a design of the proposed magnetic proximity probe, wherein the probe includes a scalar magnetic field sensor and a directional magnetic field sensor formed on opposite sides of a same dielectric substrate 1. The scalar magnetic field sensor comprises a thin film 2 formed on the dielectric substrate 1, whose electrical resistance depends on magnetic flux density but not its direction. The film 1 is made from materials with isotropic magnetoresistance, such as polycrystalline lanthanum-strontium-manganese oxide, lanthanum-calcium-manganese oxide, or lanthanum-strontium-manganese-cobalt oxide. The directional magnetic field sensor comprises a thin film 3 formed on the opposite side of the same dielectric substrate 1, whose electrical resistance varies depending on magnetic flux density and its angle. The film 3 is made from materials with anisotropic magnetoresistance, such as graphene, indium antimonide, indium arsenide, tungsten diselenide, or molybdenum disulfide. A sensitivity axis Z of the directional magnetic field sensor is parallel to the normal of a plane through which the electric current flows. Both thin films 2 and 3 have conductive contact areas $4_1$, $4_2$, $4_3$, $4_4$ connected by electrically conductive wires $5_1$, $5_2$, $5_3$, $5_4$ so that the scalar and directional sensors are connected in series. A current source is connected to wires $5_1$ and $5_4$, allowing current to flow sequentially through both sensors, forming a series circuit. An additional central wire $5_2$ and wire $5_3$ allow measurement of the total circuit voltage and the voltage across each sensor individually. The entire sensor system is hermetically sealed with a filler 6 and placed on the surface of a permanent magnet 7 so that the dielectric substrate 1 is parallel to the permanent magnet's surface, and the directional sensor's sensitivity axis Z is collinear with the permanent magnet's 7 magnetization vector M.

Fig.2 shows a similar probe design where the scalar and directional sensors are also formed on opposite sides of the single polycrystalline substrate 1. In this configuration, the hermetically sealed sensor system is placed on the permanent magnet 7 so that the dielectric substrate 1 is perpendicular to the permanent magnet's 7 surface, and the directional sensor's sensitivity axis Z is also perpendicular to the permanent magnet's magnetization vector M.

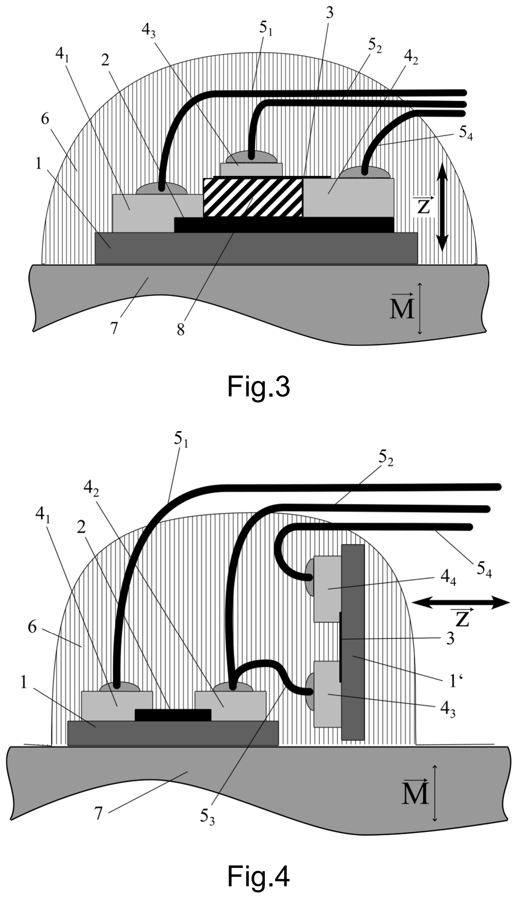

Fig.3 shows an alternative design of the proposed probe, wherein the both sensors are formed on the same side of the dielectric substrate 1. In this configuration the thin films 2 and 3 of the scalar magnetic field sensor and the directional magnetic field sensor are arranged on the same side of dielectric substrate 1 and separated by a dielectric interlayer 8. In this design, the connecting conductive wire $5_3$ and contact area $4_4$ can be omitted, as their function is now performed by the connecting contact area $4_2$. The assembled and hermetically sealed sensor system is mounted on the surface of the permanent magnet 7 so that the dielectric substrate 1 is parallel to the permanent magnet's 7 surface, and the directional sensor's sensitivity axis Z is collinear with the permanent magnet's magnetization vector M.

Fig.4 shows another design of the proposed probe wherein the thin films 2 and 3 of the scalar and directional sensors are formed on separate dielectric substrates 1 and 1' arranged perpendicular to each other. The hermetically sealed sensor system is mounted on the surface of the permanent magnet 7 so that dielectric substrate 1 is parallel to the permanent magnet's surface, while dielectric substrate 1' is perpendicular to it, and the directional sensor's sensitivity axis Z is perpendicular to the magnet's magnetization vector M.

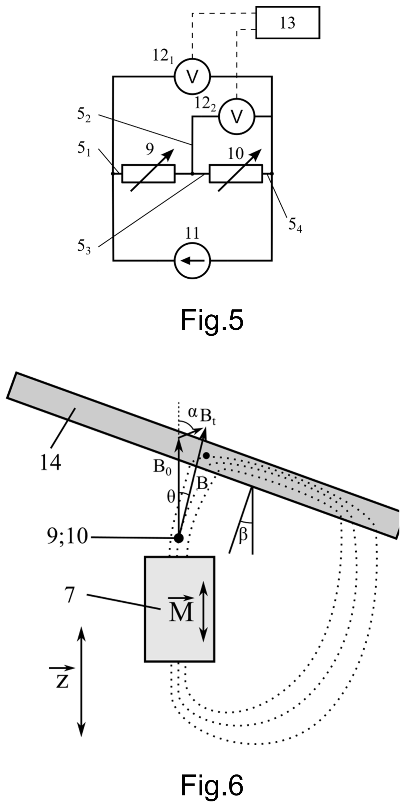

Fig.5 shows the wiring diagram for connecting the thin films of the scalar and directional sensors into a series electrical circuit using connecting wires. Thin film 2 and the contact areas $4_1$ and $4_2$ formed on it form a scalar sensor 9. Thin film 3 and the contact areas $4_3$ and $4_4$ formed on it form the directional sensor 10. The electric current source 11 is connected via wires $5_1$ and $5_4$ so that current flows sequentially through the thin films 2 and 3 of both sensors 9 and 10. Voltmeter $12_1$ is connected to wires $5_1$ and $5_4$ to measure the total circuit voltage. Voltmeter $12_2$ is connected in parallel to the directional sensor 10 via wires $5_2$ and $5_4$. Outputs of the voltmeters $12_1$ and $12_2$ are connected to a data processing unit 13, which is configured to determine the magnetic flux value and direction generated by the target 14 based on the measured voltages. Using this information, and knowing the target's geometry and material, the system can determine the target's distance and orientation relative to the probe.

Fig.6 shows the scheme for measuring distance and angle relative to the target surface 14.

## Proposed Probe operation

An electric current is passed through the thin film 2 of the scalar sensor 9, whose electrical resistance varies depending on magnetic flux density but not its direction and through the thin film 3 of the directional sensor 10, whose electrical resistance varies depending on magnetic flux density and its angle relative to the sensor plane. At the same time two voltages are measured in the circuit (the total circuit voltage and the voltage across one sensor or voltage of both sensors individually). The measured voltage values are sent to the data processing unit 13, which, based on a pre-calibrated map of voltage values versus magnetic flux density and its angle relative to the directional sensor's sensitivity axis Z, determines the magnetic flux density induced by the target and its angle to the Z-axis.

By using two magnetic field sensors, one scalar sensor 9 and other directional sensor 10, and analysing the response of both sensors measured by the voltmeters $12_1$, $12_2$, the set of possible directions of the magnetic flux density vector from the surface of the sphere is reduced to a circle.

Absolute Value of Magnetic Flux Density |B|:

$$|B|=(B_x^2+B_y^2+B_z^2)^{1/2}; \quad (1)$$

Here, $B_x$, $B_y$, and $B_z$ are the components of magnetic flux density in the Cartesian coordinate system. The square of equation (1) represents a sphere with radius |B|. If two sensors are used, one measuring the absolute value of magnetic flux density and the other measuring one component (e.g., $B_z$), then the unknowns are $B_x$ and $B_y$. Rearranging the equation (1) gives the relationship between the unknowns Bx and By:

$$B_x^2+B_y^2=|B|^2-B_z^2; \quad (2)$$

Equation (2) represents a circle with radius $(|B|^2-B_z^2)^{1/2}$. This is a closed curve, not a surface, so the directional uncertainty of the magnetic field is reduced. The angle to the directional sensor's sensitivity axis ($\theta$) can be found:

$$\theta =\cos^{-1}[B_z/|B|]; \quad (3)$$

Thus, by using scalar and directional magnetic field sensors mounted on a permanent magnet, the system provides not only information about the target's distance but also the direction of its magnetic field.

Placing the magnetic flux density sensor in the field created by a permanent magnet shifts the operating point of the proximity sensor to a specific magnetic flux density value at the sensor's position.

When the magnet's field direction M coincides with the directional sensor's sensitivity axis Z, the magnet's field is:

$$B_0=\{0,0,B_{z0}\}; \quad (4)$$

When a ferromagnetic or diamagnetic target (14) appears in the magnet's field (Fig. 6), it creates its own field, which at the sensor position can be described as:

$$B_t=|B_t|\{0,\sin \alpha ,\cos \alpha \};(5)$$

where $\alpha$ is the angle of the target's magnetic flux vector relative to the sensor's sensitivity axis Z.

The total magnetic flux density is then:

$$B=\{0, |B_t| \sin \alpha, B_{z0}+|B_t| \cos \alpha\};(6)$$

Magnetoresistive sensors often exhibit sensitivity (resistance change with magnetic field) that depends on the field value. The proposed probe configuration allows adjusting the magnetic flux density acting on the sensors by changing the magnet's magnetization and the distance between the magnet and the sensors, optimizing the operating point for sensitivity.

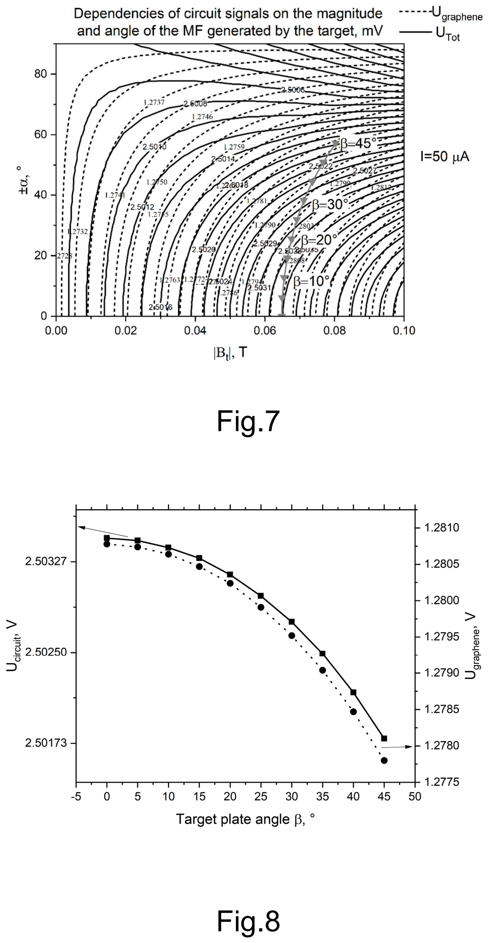

During operation, two voltages are measured (the total circuit voltage and the voltage across one or both sensors). Using calibration data (Fig. 7), where solid curves represent equipotential lines of total circuit voltage versus the target's magnetic flux density $|B_t|$ and its angle $\alpha$ to the Z-axis, the induced magnetic flux density and its angle are determined. These values can then be calibrated to the target's distance and angle $\beta$. Fig. 7 's dashed line shows the voltage response of a graphene-based directional sensor when the angle $\beta$ of a ferromagnetic plate (example target) located 3 mm from the sensors changes relative to the Z-axis. Fig. 8 shows the dependence of the entire circuit voltage and the directional sensor voltage on the plate's angle $\beta$ in this configuration.

The voltages in the circuit of the connected magnetic sensors depend on the magnetic flux density and its angle relative to the directional sensor's sensitivity axis Z. By measuring two voltages (the voltage across the entire circuit and the voltage across either sensor, or both), and using pre-calibrated data (Fig. 6), the magnetic flux density generated by the target and its direction can be determined both graphically and numerically. Fig.8 shows the response signals of the proximity sensor as the angle between the normal of the ferromagnetic plate (target 14) and the directional sensor's sensitivity axis Z changes.

### Claims

1. Magnetic proximity probe, comprising a scalar magnetic field sensor (9) and a permanent magnet (7) in a magnetic field of which said scalar magnetic field sensor is arranged having a thin film (2) of a material whose electrical resistance varies depending on the magnetic flux density but does not depend on its direction, formed on a dielectric substrate (1), **characterized in that** the probe additionally comprises a directional magnetic field sensor (10) having a thin film (3) of a material the electrical resistance of which varies depending on the magnetic flux density and its angle to a sensitivity axis Z of the directional magnetic field sensor (10), formed on the dielectric substrate (1), wherein both said scalar and directional magnetic field sensors (9, 10) are arranged in the magnetic field created by the permanent magnet (7) so that the sensitivity axis Z of said directional magnetic field sensor (10) is collinear or perpendicular to a magnetization vector M of the permanent magnet (7), and electrically conductive wires are connected to both said sensor thin films (2, 3), forming a sensor system that is hermetically sealed, and said electrically conductive wires are intended:

- for the connection of an electric current source (11) to the thin films (2, 3) of the sensors so that the electric current of the electric current source (11) can flow sequentially through the thin films (2 and 3) of the said scalar and directional sensors (9 ,10), forming a serial electric circuit,
- for the connection voltage measuring means $(12_1, 12_2)$, enabling measurement of the voltage of the entire said series circuit and the voltage of any of the sensors (9, 10) separately or the voltage of both sensors (9, 10) together,

and a means of data processing (13) is provided, configured so that based on the voltage values measured by the voltage measuring means $(12_1, 12_2)$ it could determine a value and a direction of a magnetic flux created by the target (14), and from this information, knowing the target's geometry and material, it could determine the distance and orientation of the target (14) relative to the probe.

2. The probe according to claim 1, **wherein** the respective thin films (2) and (3) of the scalar magnetic flux sensor (9) and the directional magnetic flux sensor (10) in the sensor system are formed on the same dielectric substrate (1) on opposite sides thereof, and the dielectric substrate (1) is arranged on the surface of the permanent magnet (7) parallel to or perpendicular to it, so that the sensitivity axis Z of the directional sensor (10) is respectively collinear or perpendicular to the magnetization vector M of the permanent magnet (7).

3. The probe according to claim 1, **wherein** the respective thin films (2) and (3) of the scalar magnetic flux sensor (9) and the directional magnetic flux sensor (10) in the sensor system are arranged on one side of the same dielectric substrate (1), wherein the dielectric substrate (1) is arranged on the surface of the permanent magnet (7) parallel to it, and the thin films (2) and (3) of the scalar magnetic flux sensor (9) and the directional magnetic flux sensor (10) are arranged on the dielectric substrate (1) one above the other, which are separated by a dielectric interlayer (8), and the sensitivity axis Z of the directional magnetic flux sensor (10) is collinear with the magnetization vector M of the permanent magnet (7).

4. The probe according to claim 1, **wherein** the thin films (2) and (3) of the scalar magnetic flux sensor (9) and the directional magnetic flux sensor (10) in the sensor system are formed respectively on separate dielectric substrates (1) and (1'), which are arranged on the surface of the permanent magnet (7), one parallel to it, and the other perpendicularly, so that the sensitivity axis Z of the directional sensor (10) is perpendicular to the magnetization vector M of the permanent magnet.

5. The probe according to claim 1, **wherein** the probe is configured with the possibility of changing the distance between the permanent magnet (7) and the sensor system, thereby changing density of the magnetic flux created at the position of the thin films (2, 3).

6. The probe according to any one of claims 1-4, **wherein** the material of the thin film (2) of the scalar sensor (9), whose electrical resistance varies depending on magnetic flux density but does not depend on its direction, is selected from materials **characterized by** isotropic magnetoresistance, such as polycrystalline lanthanum-strontium-manganese oxide, lanthanum-calcium-manganese oxide, or lanthanum-strontium-manganese-cobalt oxide.

7. The probe according to any one of claims 1-4, **wherein** the thin film (3) material of the directional sensor (10), whose electrical resistance varies depending on magnetic flux density and its angle relative to the directional sensor's sensitivity axis Z, is selected from materials **characterized by** anisotropic magnetoresistance, such as graphene, indium antimonide, indium arsenide, tungsten diselenide, or molybdenum disulfide.

Fig.1

Fig.2

Fig.3

Fig.4

Fig.5

Fig.6

EP 4 764 575 A1

Dependencies of circuit signals on the magnitude and angle of the MF generated by the target, mV

Fig.7

Fig.8

Europäisches
Patentamt

European
Patent Office

Office européen
des brevets

# EUROPEAN SEARCH REPORT

**Application Number**

EP 25 21 4731

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | RASUOLE LUKOSE ET AL: "Hybrid graphene-manganite thin film structure for magnetoresistive sensor application", NANOTECHNOLOGY IOP PUBLISHING, ENGLAND, vol. 30, no. 35, 11 June 2019 (2019-06-11) , page 355503, XP020342394, ISSN: 0957-4484, DOI: 10.1088/1361-6528/AB201D [retrieved on 2019-06-11] | 1,5-7 | INV.<br>G01R33/00<br>G01R33/038<br>G01R33/09<br>G01D5/14 |
| Y | * figures 1-5 *<br>* Section 3.1 *<br>* Section 3.2 *<br>* Section 3.4 *<br>----- | 2-4 | |
| Y | US 2021/111284 A1 (VIG RAVI [US] ET AL) 15 April 2021 (2021-04-15)<br>* figure 21 *<br>----- | 2-4 | |
| | | | **TECHNICAL FIELDS SEARCHED (IPC)**<br><br>G01R<br>G01D |

The present search report has been drawn up for all claims

| Place of search | Date of completion of the search | Examiner |
|---|---|---|
| Munich | 8 May 2026 | Philipp, Peter |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 21 4731

This annex lists the patent family members relating to the patent documents cited in the above-mentioned European search report.
The members are as contained in the European Patent Office EDP file on
The European Patent Office is in no way liable for these particulars which are merely given for the purpose of information.

08-05-2026

| Patent document cited in search report | Publication date | Patent family member(s) | Publication date |
|---|---|---|---|
| US 2021111284 A1 | 15-04-2021 | CN 104321661 A | 28-01-2015 |
| | | CN 107797079 A | 13-03-2018 |
| | | EP 2817646 A2 | 31-12-2014 |
| | | EP 4102187 A1 | 14-12-2022 |
| | | JP 6178401 B2 | 09-08-2017 |
| | | JP 6270900 B2 | 31-01-2018 |
| | | JP 2015514207 A | 18-05-2015 |
| | | JP 2016176951 A | 06-10-2016 |
| | | JP 2018119955 A | 02-08-2018 |
| | | JP 2020064067 A | 23-04-2020 |
| | | JP 2021051084 A | 01-04-2021 |
| | | JP 2022081544 A | 31-05-2022 |
| | | KR 20140144209 A | 18-12-2014 |
| | | US 2013249029 A1 | 26-09-2013 |
| | | US 2017278981 A1 | 28-09-2017 |
| | | US 2019157465 A1 | 23-05-2019 |
| | | US 2021111284 A1 | 15-04-2021 |
| | | US 2022310853 A1 | 29-09-2022 |
| | | US 2023261118 A1 | 17-08-2023 |
| | | US 2024222526 A1 | 04-07-2024 |
| | | WO 2013141981 A2 | 26-09-2013 |

EPO FORM P0459

For more details about this annex : see Official Journal of the European Patent Office, No. 12/82

**REFERENCES CITED IN THE DESCRIPTION**

**Patent documents cited in the description**

- EP 2525193 A1
- US 9733058 B2
- EP 3893011 B1
- US 8189302 B2